# EUROPÄISCHE PATENTSCHRIFT

(11) **EP 3 312 881 B1**
(45) Veröffentlichungstag und Bekanntmachung des Hinweises auf die Patenterteilung: **15.06.2022**
(21) Anmeldenummer: 17195873.9
(22) Anmeldetag: 11.10.2017
(51) Int. Cl.: H01L 25/075, H01L 33/60

(54) **CSP LED-MODUL MIT REFLEXIONSMITTEL**
CSP LED MODULE WITH REFLECTION AGENT
MODULE À LED CSP POURVU DE MOYEN DE RÉFLEXION

(30) Priorität: 19.10.2016 DE 202016105841 U
(43) Veröffentlichungstag der Anmeldung: 25.04.2018
(73) Patentinhaber: Tridonic GmbH & Co. KG, 6850 Dornbirn (AT)
(72) Erfinder: Gründling, Vladimir, 8280 Fürstenfeld (AT); Janisch-Lang, Franz, 8262 Ilz (AT); Kusterle, Peter, 8380 Jennersdorf (AT); Köberl, Karl, 8383 Martin an der Raab (AT)
(74) Vertreter: Rupp, Christian

(56) Entgegenhaltungen:
- CN-A- 104 776 396
- CN-U- 205 595 364
- US-A1- 2007 228 392
- US-A1- 2010 149 783
- US-A1- 2010 320 482
- US-A1- 2011 032 702
- US-A1- 2014 008 669
- US-A1- 2014 138 725
- US-A1- 2015 316 215
- J-Std-012: "JOINT INDUSTRY STANDARD IMPLEMENTATION OF FLIP CHIP AND CHIP SCALE TECHNOLOGY COORDINATED BY THE SURFACE MOUNT COUNCIL I N D U", , 1 January 1996 (1996-01-01), XP055558986, Retrieved from the Internet: URL:http://www.ipc.org/toc/j-std-012.pdf [retrieved on 2019-02-19]

## Beschreibung

Die vorliegende Erfindung betrifft ein LED Modul mit CSP LEDs und dazwischenliegenden Reflexionsmittel, sowie einen optimierten LED Strahler aufweisend ein derartiges LED Modul.

Farbkonvertierte LED-Chips und LED-Module aufweisend einen oder mehrere LED-Chips sind aus dem Stand der Technik hinreichend bekannt. Üblicherweise wird ein LED Chip auf einen Träger aufgebracht und anschließend mit einer einen Leuchtstoff aufweisenden Vergussmasse vergossen. Die Vergussmasse kann beispielsweise eine Matrix aus Silikonmaterial sein, in welche Leuchtstoffpartikel eingebracht sind, welche das vom LED Chip emittierte Licht wenigstens teilweise in Licht einer höheren Wellenlänge umwandeln. Das so erhaltene Mischlicht aus beispielsweise blauem Primärlicht der LED und gelbem Sekundärlicht der Leuchtstoffpartikel ermöglicht die Bereitstellung einer Weißlichtquelle.

Derartige LED Module mit mehreren LED Chips können beispielsweise durch ein sogenanntes Chip-on-Board Verfahren hergestellt werden, wobei auf einer Oberfläche des Trägers die einzelnen LED Chips zunächst aufgebracht und mit den Leiterbahnen des Trägers beispielweise durch Drahtbonden elektrisch kontaktiert, sowie anschließend individuell mit Leuchtstoff enthaltender Vergussmasse vergossen werden.

Ein Nachteil dieser Herstellungsvariante ist die relative geringe Leuchtdichte der resultierenden LED Module, die hohen Kosten und die geringe Widerstandsfähigkeit der LED Module.

Eine jüngere Alternative hierzu ist die Verwendung von sogenannten "Chip-Scale Package" LED-Chips (CSP LED-Chips), welche auf einen Träger aufgebracht werden. Derartige CSP-LED Chips werden bereits bei der Chip-Herstellung auf Wafer-Ebene mit vorzugsweise Leuchtstoff enthaltender Vergussmasse umschlossen, bevor die LED Chips in einem "Dicing"-Schritt in einzelne individuell mit Vergussmasse und/oder Leuchtstoff beschichtete LED Chips getrennt werden. Bei der Verwendung von CSP LED Chips entfällt demnach der zusätzliche Herstellungsschritt des Vergießens der LED Chips mit Vergussmasse. Außerdem können die CSP LED Chips näher zueinander angeordnet werden. Ein Nachteil derartiger LED Module ist die gegenseitige Beeinflussung einzelner LED Chips des LED Moduls durch Absorption, welche zu Farbverschiebungen führen kann und welche die Lichtausbeute des LED Moduls negativ beeinträchtigen.

EP 2 927 970 A1 beschreibt ein LED Modul mit CSP LED-Chips, in welchem jeder zweite CSP LED Chip mit einer seitlichen Lichtblockierungsoberfläche ausgestattet ist, um das gegenseitige Eintreten von emittiertem Licht eines CSP LED Chips in einen benachbarten CSP LED Chip zu verhindern. Dies hat jedoch die Nachteile einer erhöhten Komplexität des resultierenden LED Moduls und einer Verringerung der Effizienz der Lichtemission.

CN 104 776 396 A beschreibt ein LED-Modul das LED-Chips und Reflexionsmittel aufweist die die LED-Chips jeweils seitlich umgeben.

Die Aufgabe der vorliegenden Erfindung ist es ein verbessertes LED Modul mit CSP LED Chips bereitzustellen, welches die Nachteile des Standes der Technik überwindet und eine verbesserte Lichtemission, insbesondere eine erhöhte Leuchtdichte des emittierten Lichts ermöglicht.

Diese Aufgabe wird durch den unabhängigen Anspruch gelöst. Die abhängigen Ansprüche stellen vorteilhafte Weiterbildungen des erfindungsgemäßen Gegenstands dar.

Durch die Reflexionsmittel der vorliegenden Erfindung wird die Einkopplung von emittierten Lichtstrahlen eines CSP LED-Chips in einen anderen CSP LED-Chip des LED Moduls erfolgreich verhindert. Die Reflexionsmittel ermöglichen weiterhin, dass seitlich emittiertes Licht eines CSP LED Chips nicht blockiert, sondern in Lichtabstrahlrichtung des LED Moduls reflektiert wird.

Bei den "CSP LED Chips" handelt es sich um sogenannte "Chip Scale Package" LEDs. Dies bedeutet, dass die LED Chips bereits während der Chipherstellung individuell mit Vergussmasse umschlossen wurden. Die CSP LED Chips weisen auf ihrer Rückseite p- und n-Kontakte auf, mit welchen diese direkt beispielsweise mit auf dem Träger angeordneten Leiterbahnen kontaktiert werden können. Die CSP LED Chips können beispielsweise mit einer "Pick-and-place" Maschine auf dem Träger angeordnet werden.

Die "Dies" der CSP LED Chips sind vorzugsweise blaues oder ultraviolettes Licht emittierende LED Chips. Die Vergussmasse der CSP LED Chips kann aus transparentem Polymermaterial bestehen und ist vorzugsweise eine Silikon- oder Epoxidharzschicht. Die Vergussmasse weist darin eingebrachte Leuchtstoffpartikel auf. Die Leuchtstoffpartikel in der Vergussmasse bzw. Leuchtstoffschicht der CSP LEDs sind vorzugsweise gelb und/oder grün emittierende Leuchtstoffpartikel. Diese wandeln das von dem LED Chip emittierte Primärlicht wenigstens teilweise in Licht einer höheren Wellenlänge um. Das resultierende Mischlicht der jeweiligen CSP LED Chips ist vorzugsweise weißes Mischlicht.

Die einzelnen CSP LED Chips weisen vorzugsweise eine Höhe h1 von zwischen 0,2 bis 1,2mm, mehr bevorzugt zwischen 0,7 und 0,9mm auf.

Die Seitenlänge der CSP LED Chips liegt vorzugsweise zwischen 0,3 bis 2,5mm, mehr bevorzugt zwischen 1,0 und 2,0mm.

Die einzelnen CSP LED Chips sind in Draufsicht vorzugsweise quadratisch oder rechteckig geformt. Die sich in Draufsicht gegenüberliegenden äußeren Seitenflächen jedes CSP LED Chips sind demnach vorzugsweise parallel zueinander angeordnet.

Der Träger des LED Moduls ist vorzugsweise ein Trägersubstrat, auf welchem die CSP LED Chips angeordnet sind. Die Oberfläche des Trägers, auf welcher die CSP LED Chips angeordnet sind ist vorzugsweise eben. Der Träger kann eine Leiterplatte sein. Der Träger ist vorzugsweise ein sogenannter IMS Träger ("Insulated metal substrate").

Der Träger kann ebenso aus FR4, CM3 Material und/oder aus Metall wie beispielsweise Aluminium bestehen.

Die Oberfläche des Trägers kann Leiterbahnen aufweisen, mit welchen die CSP LED Chips elektrisch verbunden sind. Der Träger weist vorzugsweise eine quadratische oder rechteckige Form in Draufsicht auf.

Die Oberfläche des Trägers, auf welcher die CSP LED Chips angeordnet sind, kann hochreflektierend ausgeprägt sein. Dies kann durch das Trägermaterial erzielt werden. Alternativ kann auf den Träger eine hochreflektierende Schicht, beispielsweise aus Aluminium oder Silber, aufgebracht werden, auf welcher die CSP LED Chips angeordnet sind.

Der Träger weist vorzugsweise eine erhöhte Wärmeleitfähigkeit auf. Der Träger kann ausgeprägt sein, um als Wärmesenke zu fungieren. Die Materialstärke des Trägers liegt vorzugsweise zwischen 0,5 und 2mm, vorzugsweise zwischen 0,7 und 1,6mm. Auf der Rückseite des Trägers kann ein separater Kühlkörper oder eine Wärmesenke angeordnet sein. Dieser bzw. diese kann auch integral mit dem Träger ausgeprägt sein.

Die Reflexionsmittel umgeben die einzelnen CSP LED Chips des LED Moduls seitlich. Dies bedeutet, dass die Reflexionsmittel sich in Draufsicht auf das LED Modul vorzugsweise ohne Unterbrechung um die Seitenflächen der individuellen CSP LED Chips erstrecken. Als Seitenflächen im Sinne der vorliegenden Erfindung werden die lateralen Flächen des jeweiligen CSP LED Chips verstanden, welche im montiertem Zustand des CSP LED Chips im Wesentlichen senkrecht zur Trägeroberfläche orientiert sind, also nicht die jeweilige Ober- und Unterseite des CSP LED Chips.

Die Reflexionsmittel sind wenigstens teilweise von den Seitenflächen der jeweiligen CSP LED Chips beabstandet. Die Reflexionsmittel bedecken vorzugsweise nicht die gesamte Seitenfläche des jeweiligen CSP LED Chips, um welchen sie sich erstrecken. Nach der Erfindung sind die Reflexionsmittel von den jeweiligen Seitenflächen der CSP LED Chips beabstandet. Dies bedeutet, dass kein Kontakt zwischen den Reflexionsmittel und den Seitenflächen der jeweiligen CSP LED Chips vorhanden ist.

Hierbei können die Reflexionsmittel den jeweiligen CSP LED Chip in einem homogenen Abstand umgeben. Die Reflexionsmittel können die jeweiligen CSP LED Chips in Draufsicht rechteckförmig umgeben.

Der Abstand von den Reflexionsmittel zu den jeweiligen Seitenflächen des CSP LED Chips liegt zwischen 0,05 und 1mm, bevorzugt zwischen 0,1 und 0,7mm, und am bevorzugtesten zwischen 0,1 und 0,2mm.

Die Reflexionsmittel sind vorzugsweise auf der Oberfläche des Trägers angeordnet und/oder erstecken sich von dieser. Die Reflexionsmittel des LED Moduls sind vorzugsweise hochreflektierend ausgeprägt.

Die Reflexionsmittel sind vorzugsweise derart geformt, dass diese einen Lichteintritt von emittiertem Licht eines CSP LED Chips in einen anderen, insbesondere in einen benachbarten, CSP LED Chip des LED Moduls verhindern. Die Reflexionsmittel erstrecken sich vorzugsweise zu einer Höhe h, welche gleich oder größer ist, als die Höhe h1 der jeweiligen CSP LED Chips.

Die Reflexionsmittel weisen vorzugsweise sich in Lichtaustrittsrichtung des LED Moduls erweiternde Innenflächen auf. Die Innenflächen der Reflexionsmittel sind derart angeordnet, dass diese den jeweiligen Seitenflächen des jeweiligen CSP LED Chips gegenüberliegen und/oder an diese wenigstens teilweise angrenzen. Die Innenflächen weisen vorzugsweise einen homogenen Neigungswinkel gegenüber den jeweiligen Seitenflächen des CSP LED Chips auf. Der Neigungswinkel beträgt vorzugweise zwischen 20 und 80°, mehr bevorzugt zwischen 30 und 60° gegenüber der Vertikalen. Die jeweiligen Innenflächen der Reflexionsmittel sind vorzugsweise eben ausgeprägt.

Der resultierende Halbwinkel des vom LED Modul ausgestrahlten Lichts liegt vorzugsweise bei weniger als 120°.

Die Reflexionsmittel weisen vorzugsweise eine Mehrzahl von miteinander verbundenen Seitenwänden auf. Die Seitenwände sind im Wesentlichen parallel zu den Seitenflächen der jeweiligen CSP LED Chips angeordnet, welche diese umgeben. Die Seitenwände können durch ein in seitlicher Schnittansicht dreieckig-förmiges Profil gebildet sein. Das Profil der Seitenwände kann vorzugsweise wenigstens teilweise hohl sein.

Die Reflexionsmittel können ein vorzugsweise einstückig geformter gitterförmiger Reflektor sein. In einer besonders bevorzugten Ausführungsform sind die Reflexionsmittel eine gitterförmige Mikro-Reflexionsplatte.

Die Mikro-Reflexionsplatte kann aus Kunststoffmaterial sein. Beispielsweise kann die Mikro-Reflexionsplatte durch eine Kunststofffolie gebildet sein. Diese kann eine Beschichtung aufweisen, welche hochreflektierend ist. Beispielsweise kann die Reflexionsplatte eine hochreflektierenden Metalloberfläche aufweisen. Diese kann durch Metallisierung des Kunststoffmaterials geformt sein.

Die Mikro-Reflexionsplatte kann alternativ aus einem Metall geformt sein. Beispielsweise kann die Mikro-Reflexionsplatte aus Aluminium bestehen, beispielsweise eine Aluminiumfolie.

Die Mikro-Reflexionsplatte kann durch Umformen, Kalt- oder Warmpressen, oder durch eine Spritzgießtechnik herstellbar sein.

Die Mikro-Reflexionsplatte kann zusätzlich mit einer hochreflektierenden Beschichtung versehen sein.

Die Mikro-Reflexionsplatte weist vorzugsweise eine Vielzahl von Ausnehmungen auf, in welche jeweils die einzelnen CSP LED Chips im montierten Zustand der Mikro-Reflexionsplatte auf dem Träger ragen. Die einzelnen CSP LED Chips ragen dabei derart in die einzelnen Ausnehmungen, dass die Seitenwände des Reflexionsplatte die einzelnen CSP LED Chips umgeben.

Die Reflexionsmittel sind vorzugsweise mit Hilfe einer Klebeverbindung auf dem Träger angeordnet. Beispielsweise können die Reflexionsmittel mit Hilfe von zuvor auf den Träger aufgetragenen Silikontropfen, auf welche die Reflexionsmittel gelegt und welche anschließen ausgehärtet werden mit dem Träger verbunden werden.

Die Reflexionsmittel können auch mit alternativen Verbindungsmitteln wie beispielsweise mittels Presspassung oder Steckverbindung auf dem Träger befestigt werden.

Die Reflexionsmittel können beispielsweise mit einer "Pick-and-place" Maschine auf dem Träger angeordnet werden. Hierdurch wird eine besonders einfache Fertigung des LED Modules erzielt.

Die Reflexionsmittel weisen vorzugsweise eine homogene Dicke h in Seitenansicht auf. Die Dicke h liegt vorzugsweise zwischen 0,2 bis 1,5, mehr bevorzugt zwischen 0,7 bis 1mm.

Das LED Modul weist vorzugsweise ein Lichtfeld mit einer Vielzahl von CSP LED Chips auf, welche in einem homogenen Abstand zueinander angeordnet sein können. Die einzelnen CSP LED Chips sind vorzugsweise in einem Seitenabstand von 0,5 bis 4mm, mehr bevorzugt in einem Abstand von 1, 0 bis 3,0mm zueinander angeordnet. Die einzelnen CSP LED Chips sind vorzugsweise in einer matrizen- bzw. gitterförmigen Anordnung auf dem Träger positioniert.

Das LED Modul weist vorzugsweise 5 bis 40 CSP LED Chips auf. Mehr bevorzugt weist das LED Module zwischen 7 bis 25 CSP LED Chips auf.

Das Lichtfeld, in welchem die CSP LED Chips angeordnet sind ist vorzugsweise rechteckig oder quadratisch. Das Lichtfeld kann jedoch auch im Wesentlichen kreisförmig sein.

Die Reflexionsmittel umgeben vorzugsweise jeden der auf dem Träger angeordneten CSP LED Chips seitlich.

In einem weiteren Aspekt betrifft die Erfindung einen Strahler oder eine Leuchte aufweisend wenigstens ein LED Modul wie oben beschrieben.

Nachfolgend wird die Erfindung anhand der Zeichnungen, in denen ein vorteilhaftes Ausführungsbeispiel der Erfindung dargestellt ist, beispielhaft beschrieben. In den Zeichnungen zeigen:
- Fig. 1a und 1b: zeigen eine bevorzugte Ausführungsform der Einzelteile des erfindungsgemäßen LED Moduls, den Träger mit aufgebrachten CSP LED Chips und das Reflexionsmittel.
- Fig. 2: zeigt eine bevorzugte Ausführungsform des zusammengesetzten LED Moduls.
- Fig. 3: zeigt eine seitliche Schnittansicht des erfindungsgemäßen LED Moduls.

Das erfindungsgemäße LED Modul 10 weist einen Träger 1 auf, welcher beispielsweise eine Leiterplatte sein kann. Auf einer Oberfläche 1a des Trägers 1, welche vorzugsweise plan ausgestaltet ist, sind wenigstens zwei, vorzugsweise mehrere CSP LED Chips 2 angeordnet. Die Materialstärke t des Trägers liegt zwischen 0,5 und 2mm, vorzugsweise zwischen 0,7 und 1,6mm

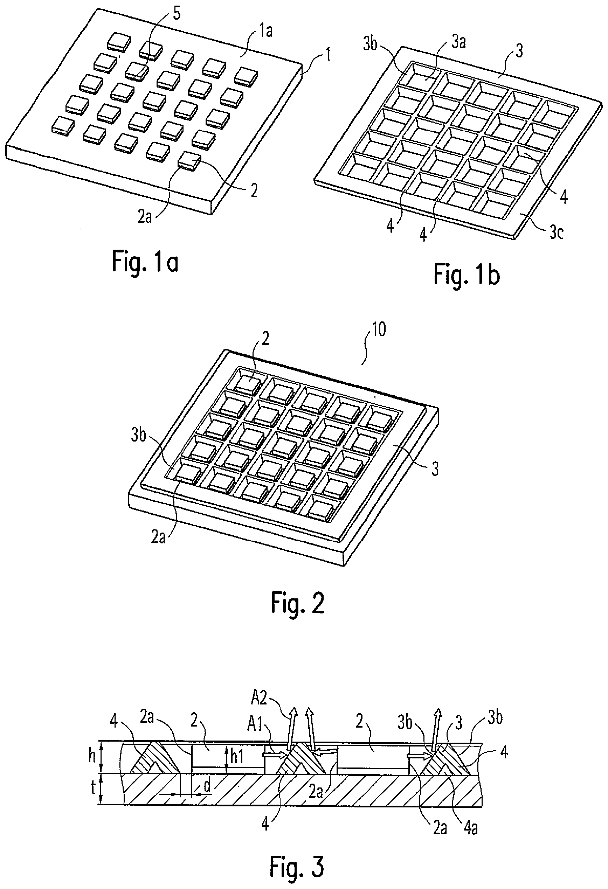

Die CSP LED Chips 2 sind vorzugsweise in einem geordneten Schema, beispielsweise matrizenförmig auf der Oberfläche 1a angeordnet, wie in Fig. 1a gezeigt. Die CSP LED Chips 2 bilden somit ein Lichtfeld 5 auf dem Träger 1. Die CSP LED Chips 2 sind dabei vorzugsweise mit ihren jeweiligen Seitenflächen 2a parallel zueinander angeordnet. Der Abstand von sich gegenüberliegenden Seitenflächen 2a von benachbarten CSP LED Chips 2 liegt vorzugsweise zwischen 0,5 und 4mm, mehr bevorzugt zwischen 1,0 und 3,0mm.

Das LED Modul 10 weist ferner Reflexionsmittel 3 auf, welche die jeweiligen CSP LED Chips 2 seitlich umgeben. Die Reflexionsmittel 3 sind vorzugsweise hochreflektierend ausgeprägt.

Die Reflexionsmittel 3 können durch einen gitterförmigen Reflektor gebildet sein. In einer besonders bevorzugten Ausführungsform sind die Reflexionsmittel 3 durch eine vorzugsweise gitterförmige Mikro-Reflexionsplatte oder Mikro-Reflexionsfolie geformt. Die Mikro-Reflexionsplatte 3 weist eine homogene Stärke bzw. Höhe h zwischen 0,2 bis 1,5, mehr bevorzugt zwischen 0,7 bis 1mm auf.

Demgegenüber weisen die einzelnen CSP LED Chips vorzugsweise eine Höhe h1 von zwischen 0,2 bis 1,2mm, mehr bevorzugt zwischen 0,7 und 0,9mm auf.

Die Reflexionsmittel 3 erstrecken sich somit vorzugsweise von der Trägeroberfläche 1a zu einer Höhe h, welcher größer ist als die Höhe h1 der CSP LED Chips 2.

Die Mikro-Reflexionsplatte 3 weist Ausnehmungen 3a auf, welche konform zu der Anordnung der CSP LED Chips 2 auf dem Träger 1 angeordnet sind. Die Ausnehmungen 3a sind demnach so angeordnet, dass die jeweiligen CSP LED Chips 2 im zusammengesetzten LED Modul 10 (siehe Fig. 2) in diese hineinragen. Die Ausnehmungen 3a sind in Draufsicht auf das LED Modul 10 vorzugsweise rechteckig, insbesondere guadratisch.

Die Mikro-Reflexionsplatte 3 weist miteinander verbundene Seitenwände 4 auf, welche die jeweiligen CSP LED Chips 2 umgeben. Die Seitenwände erstrecken sich in Draufsicht auf des LED Modul 10 vorzugsweise im Wesentlichen parallel zu den jeweiligen Seitenflächen 2a des umgebenen CSP LED Chips 2. Die Mikro-Reflexionsplatte 3 kann einen äußeren Rand 3c aufweisen, welcher die einzelnen Seitenwände 4 und Ausnehmungen 3a umgibt.

Die Seitenwände 4 weisen vorzugsweise geneigte Innenflächen 3b auf, welche derart angeordnet sind, dass sich die Reflexionsmittel 3 in eine Lichtaustrittsrichtung, weg von der Trägeroberfläche 1a, erweitern. Die Innenflächen 3b weisen hierbei einen vorzugsweise homogenen Neigungswinkel gegenüber der benachbarten Seitenfläche 2a des jeweiligen CSP LED Chips 2 auf.

Die Seitenwände 4 sind in seitlicher Schnittansicht, wie in Figur 3 gezeigt, vorzugsweise dreiecksförmig ausgeprägt. Die Seitenwände 4 können teilweise hohl sein. Insbesondere können die Seitenwände einen inneren Hohlraum 4a aufweisen, welcher sich zwischen zwei gegenüberliegenden Innenflächen 3b befindet.

Wie in Figur 3 gezeigt sind die Seitenwände 4 in einem vorzugsweise homogenen Abstand d zu den jeweils gegenüberliegenden Seitenflächen 2a der CSP LED Chips 2 angeordnet. Der Abstand d wird hierbei von einer Unterkante der Innenwand 3b gemessen, welche der Seitenfläche 2a des CSP LED Chips 2 gegenüberliegt. Es liegt demnach vorzugsweise kein direkter Kontakt zwischen Reflexionsmittel 3 und den CSP LED Chips 2 vor. Der Abstand d liegt zwischen 0,05 und 1mm, bevorzugt zwischen 0,1 und 0,7mm, und am bevorzugtesten zwischen 0,1 und 0,2mm.

In einer alternativen Ausgestaltungsform kann die Innenwand 3b der Reflexionsmittel 3 zumindest an ihrer Unterkante an die Seitenwand 2a des LED Chips 2 angrenzen und sich von dieser in Richtung Lichtaustrittsrichtung, weg von der Trägeroberfläche 1a, neigen. In einer derartigen Ausgestaltung sind die Reflexionsmittel 3 nur teilweise von den umgebenen CSP LED Chips 2 beabstandet.

Wie in Figur 3 gezeigt werden die von dem CSP LED Chip 2 emittierten Lichtstrahlen A1 von den Innenwänden 3b des Reflexionsmittels 3 in Richtung Lichtaustrittsrichtung des LED Moduls 10, also weg von der Trägeroberfläche 1a reflektiert (siehe Pfeil A2). Durch die bereitgestellten Reflexionsmittel 3 wird insbesondere eine Einkopplung der Lichtstrahlen A1/A2 von einem CSP LED Chip 2 in einen benachbarten CSP LED Chip verhindert. Hierdurch wird eine Farbverschiebung des resultierenden Mischlichts des LED Moduls verhindert. Des Weiteren wird die Effizienz des LED Moduls 10 erhöht.

Erfindung wird durch die beigefügten Ansprüche definiert.

## Patentansprüche

1. LED-Modul (10), aufweisend:
einen Träger (1) mit darauf angeordneten Leiterbahnen,
wenigstens zwei auf einer Oberfläche (1a) des Trägers (1) angeordnete Chip Scale Package (CSP) LED-Chips (2), wobei die CSP LED-Chips bereits während der Chipherstellung individuell mit einer Vergussmasse, die darin eingebrachte Leuchtstoffpartikel aufweist, umschlossen wurden und auf ihrer Rückseite p- und n-Kontakte aufweisen, mit welchen diese direkt mit den auf dem Träger angeordneten Leiterbahnen kontaktiert sind; und
Reflexionsmittel (3), wobei die Reflexionsmittel (3) die CSP LED-Chips (2) jeweils seitlich umgeben, und wobei die Reflexionsmittel von den Seitenwänden (2a) der jeweiligen CSP LED-Chips (2) beabstandet sind,
wobei der Abstand zwischen CSP LED-Chips (2) und Reflexionsmittel (3) zwischen 0,05 und 1 mm beträgt.

2. LED-Modul (10) nach Anspruch 1,
wobei die Reflexionsmittel (3) derart geformt sind, dass diese einen Lichteintritt von emittiertem Licht eines LED Chips (2) in einen anderen, insbesondere in einen benachbarten, LED Chip (2) verhindern.

3. LED-Modul (10) nach Anspruch 1 oder 2,
wobei die Reflexionsmittel (3) auf der Oberfläche (1a) des Trägers (1) angeordnet sind.

4. LED-Modul (10) nach einem der vorhergehenden Ansprüche,
wobei sich die Reflexionsmittel (3) von der Trägeroberfläche (1a) zu einer Höhe (h) erstrecken, welche gleich oder höher ist, als die Höhe (h1) der jeweiligen LED Chips (2).

5. LED-Modul (10) nach einem der vorhergehenden Ansprüche,
wobei die Reflexionsmittel (3) den jeweiligen CSP LED Chip (2) in einem homogenen Abstand zu dessen Seitenwänden (2a) umgeben.

6. LED-Modul (10) nach einem der vorhergehenden Ansprüche,
wobei die Reflexionsmittel (3) die jeweiligen LED Chips (2) in Draufsicht rechteckförmig umgeben.

7. LED-Modul (10) nach einem der vorhergehenden Ansprüche,
wobei die Reflexionsmittel (3) sich in Lichtaustrittsrichtung der Reflexionsmittel erweiternde Innenflächen (3b) aufweisen, und
wobei die Innenflächen (3b) der Reflexionsmittel (3) vorzugsweise einen homogenen Neigungswinkel aufweisen.

8. LED-Modul (10) nach einem der vorhergehenden Ansprüche,
wobei die Reflexionsmittel (3) miteinander verbundene Seitenwände (4) aufweisen, und
wobei die Seitenwände (4) in seitlicher Schnittansicht vorzugsweise ein vorzugsweise hohles Dreiecksprofil aufweisen.

9. LED-Modul (10) nach einem der vorhergehenden Ansprüche,
wobei die Reflexionsmittel (3) durch einen vorzugsweise einstückigen gitterförmigen Reflektor geformt sind.

10. LED-Modul (10) nach einem der vorhergehenden Ansprüche,
wobei die Reflexionsmittel (3) durch eine Mikro-Reflexionsplatte oder Mikro-Reflexionsfolie geformt sind,
wobei die Mikro-Reflexionsplatte oder -Folie vorzugsweise aus Metall oder vorzugsweise beschichtetem Kunststoff geformt ist.

11. LED-Modul (10) nach einem der vorhergehenden Ansprüche,
wobei die Reflexionsmittel (3) mit Hilfe einer Klebeverbindung auf dem Träger (1) angeordnet ist.

12. LED-Modul (10) nach einem der vorhergehenden Ansprüche,
wobei die Reflexionsmittel (3) eine homogene Dicke (h) in Seitenansicht aufweist.

13. LED-Modul (10) nach einem der vorhergehenden Ansprüche,
wobei das LED-Modul (10) ein Lichtfeld (5) mit einer Vielzahl von CSP LED Chips (2) aufweist, welche vorzugsweise in einem homogenen Abstand zueinander angeordnet sind.

14. LED-Modul (10) nach Anspruch 13,
wobei die Reflexionsmittel (3) jeden der Vielzahl der CSP LED-Chips (2) seitlich umgeben.

15. LED Strahler aufweisend ein LED Modul gemäß einem der Ansprüche 1 bis 14.

## Claims

1. LED module (10) comprising:
a carrier (1) with strip conductors disposed thereon,
at least two chip scale package (CSP) LED chips (2) disposed on a surface (1a) of the carrier (1), wherein the CSP LED chips have already been individually encapsulated during chip production with a casting compound comprising incorporated luminescent material particles and comprise p and n contacts on their rear side by means of which they are in direct contact with the strip conductors disposed on the carrier; and
reflecting means (3), wherein the reflecting means (3) respectively laterally surround the CSP LED chips (2) and wherein the reflecting means are spaced apart from the side walls (2a) of the respective CSP LED chips (2),
wherein the distance between CSP LED chips (2) and reflecting means (3) is between 0.05 and 1 mm.

2. LED module (10) according to Claim 1,
wherein the reflecting means (3) are shaped such that they prevent light emitted by one LED chip (2) from entering another, in particular an adjacent, LED chip (2).

3. LED module (10) according to Claim 1 or 2,
wherein the reflecting means (3) are disposed on the surface (1a) of the carrier (1).

4. LED module (10) according to any one of the preceding claims,
wherein the reflecting means (3) extend from the carrier surface (1a) to a height (h) which is equal to or higher than the height (h1) of the respective LED chips (2).

5. LED module (10) according to any one of the preceding claims,
wherein the reflecting means (3) surround the respective CSP LED chip (2) at a uniform distance from its side walls (2a) .

6. LED module (10) according to any one of the preceding claims,
wherein the reflecting means (3) surround the respective LED chips (2) in a rectangular shape in plan view.

7. LED module (10) according to any one of the preceding claims,
wherein the reflecting means (3) comprise inner surfaces (3b) that widen in the light exit direction of the reflecting means, and
wherein the inner surfaces (3b) of the reflecting means (3) preferably have a uniform angle of inclination.

8. LED module (10) according to any one of the preceding claims,
wherein the reflecting means (3) comprise interconnected side walls (4), and
wherein the side walls (4) preferably have a preferably hollow triangular profile in lateral sectional view.

9. LED module (10) according to any one of the preceding claims,
wherein the reflecting means (3) are formed by a preferably one-piece grid-shaped reflector.

10. LED module (10) according to any one of the preceding claims,
wherein the reflecting means (3) are formed by a micro-reflecting plate or micro-reflecting film,
wherein the micro-reflecting plate or film is preferably made of metal or preferably coated plastic.

11. LED module (10) according to any one of the preceding claims,
wherein the reflecting means (3) is disposed on the carrier (1) with the aid of an adhesive bond.

12. LED module (10) according to any one of the preceding claims,
wherein the reflecting means (3) has a uniform thickness (h) in side view.

13. LED module (10) according to any one of the preceding claims,
wherein the LED module (10) comprises a light field (5) having a plurality of CSP LED chips (2) which are preferably disposed at a uniform distance from one another.

14. LED module (10) according to Claim 13,
wherein the reflecting means (3) laterally surround each one of said plurality of CSP LED chips (2).

15. LED spotlight comprising an LED module according to any one of Claims 1 to 14.

## Revendications

1. Module à LED (10), présentant :
un support (1) sur lequel sont agencées des pistes conductrices,
au moins deux puces LED CSP (Chip Scale Package, boîtier à puce) (2) agencées sur une surface (1a) du support (1), lesdites puces LED CSP ayant préalablement été enrobées individuellement, lors de leur production, dans une matière d'enrobage dans laquelle sont incluses des particules luminescentes et présentant sur leur face arrière des contacts p et n grâce auxquels elles sont directement connectées aux pistes conductrices agencées sur le support, et
des moyens réfléchissants (3), lesdits moyens réfléchissants (3) entourant les côtés des diverses puces LED CSP (2), et lesdits moyens réfléchissants étant espacés des bords latéraux (2a) des diverses puces LED CSP (2),
ledit espacement entre les puces LED CSP (2) et les moyens réfléchissants (3) étant compris entre 0,05 et 1 mm.

2. Module à LED (10) selon la revendication 1,
dans lequel les moyens réfléchissants (3) sont formés de façon à empêcher une entrée de lumière émise par une puce LED (2) dans une autre puce LED (2), notamment dans une puce LED voisine.

3. Module à LED (10) selon la revendication 1 ou 2,
dans lequel les moyens réfléchissants (3) sont agencés sur la surface (1a) du support (1).

4. Module à LED (10) selon l'une des revendications précédentes,
dans lequel les moyens réfléchissants (3) s'étendent depuis la surface (1a) du support jusqu'à une hauteur (h) qui est supérieure ou égale à la hauteur (h1) des diverses puces LED (2) .

5. Module à LED (10) selon l'une des revendications précédentes,
dans lequel les moyens réfléchissants (3) entourent chacune des puces LED CSP (2) avec un espacement homogène par rapport à ses bords latéraux (2a).

6. Module à LED (10) selon l'une des revendications précédentes,
dans lequel les moyens réfléchissants (3) entourent les diverses puces LED (2) selon une forme carrée, vus de dessus.

7. Module à LED (10) selon l'une des revendications précédentes,
dans lequel les moyens réfléchissants (3) présentent des surfaces intérieures (3b) allant en s'élargissant dans le sens de sortie de lumière des moyens réfléchissants, et
dans lequel les surfaces intérieures (3b) des moyens réfléchissants (3) présentent de préférence un angle d'inclinaison homogène.

8. Module à LED (10) selon l'une des revendications précédentes,
dans lequel les moyens réfléchissants (3) présentent des bords latéraux (4) reliés entre eux, et
dans lequel les bords latéraux (4) présentent de préférence un profil triangulaire de préférence creux, vus en coupe latérale.

9. Module à LED (10) selon l'une des revendications précédentes,
dans lequel les moyens réfléchissants (3) sont formés par un réflecteur de type treillis de préférence monobloc.

10. Module à LED (10) selon l'une des revendications précédentes,
dans lequel les moyens réfléchissants (3) sont formés par une plaque microréfléchissante ou une feuille microréfléchissante,
dans lequel la plaque ou feuille microréfléchissante est constituée de préférence de métal ou, de préférence, de plastique revêtu.

11. Module à LED (10) selon l'une des revendications précédentes,
dans lequel les moyens réfléchissants (3) sont agencés sur le support (1) à l'aide d'une liaison adhésive.

12. Module à LED (10) selon l'une des revendications précédentes,
dans lequel les moyens réfléchissants (3) présentent une épaisseur (h) homogène, vus de côté.

13. Module à LED (10) selon l'une des revendications précédentes,
ledit module à LED (10) présentant un champ lumineux (5) doté d'une pluralité de puces LED CSP (2) agencées de préférence avec un espacement homogène entre elles.

14. Module à LED (10) selon la revendication 13,
dans lequel les moyens réfléchissants (3) entourent les côtés de chacune des puces de la pluralité de puces LED CSP (2) .

15. Projecteur à LED présentant un module à LED selon l'une des revendications 1 à 14.
